# EUROPÄISCHE PATENTSCHRIFT

(11) **EP 3 123 844 B1**
(45) Veröffentlichungstag und Bekanntmachung des Hinweises auf die Patenterteilung: **25.10.2017**
(21) Anmeldenummer: 14809641.5
(22) Anmeldetag: 10.12.2014
(51) Int. Cl.: H05K 7/14

(54) **BUSFÄHIGES ANEINANDERREIHBARES ANSCHLUSS- UND/ODER FUNKTIONSMODUL**
BUS-CAPABLE CONNECTION MODULE AND/OR FUNCTION MODULE WHICH CAN BE CONNECTED IN ROWS
MODULE DE CONNEXION ET/OU DE FONCTION COMPATIBLE AVEC UN BUS ET POUVANT ÊTRE MIS EN SÉRIE

(30) Priorität: 28.03.2014 DE 202014101491 U
(43) Veröffentlichungstag der Anmeldung: 01.02.2017
(73) Patentinhaber: Weidmüller Interface GmbH & Co. KG, 32758 Detmold (DE)
(72) Erfinder: GAGEL, Markus, 32760 Detmold (DE); KULTURIDI, Georg, 33605 Bielefeld (DE); NIGGEMANN, Matthias, 32694 Dörentrup (DE); PÜSCHNER, Klaus, 32760 Detmold (DE); ROSE, Gorm, 33100 Paderborn (DE); SCHNATWINKEL, Michael, 32051 Herford (DE); SCHUMACHER, Ralf, 32657 Lemgo (DE); WOHLGEMUTH, Klaus, 32689 Kalletal (DE)
(74) Vertreter: Kleine, Hubertus
(86) Internationale Anmeldenummer: PCT/EP2014/077105
(87) Internationale Veröffentlichungsnummer: WO 2015/144265

(56) Entgegenhaltungen:
- WO-A1-2012/000807

## Beschreibung

Die Erfindung betrifft ein busfähiges aneinanderreihbares Anschluss- und/oder Funktionsmodul zur Steuerung und/oder Überwachung technischer Prozesse mit einem blockartigen Aufbau. Das Modul weist eine Basiseinheit zur Befestigung an einer Tragschiene auf, wobei die Basiseinheit in Anreihrichtung an jeder Seite wenigstens eine Busleiterklemme zur Weiterleitung von wenigstens einem Energie- und/oder Datenbus in Anreihrichtung an benachbarte Anschluss- und/oder Funktionsmodule und wobei ein auf die Basiseinheit aufgesetzter Gehäusedeckel vorgesehen ist.

Derartige busfähige und aneinanderreihbare Anschluss- und/oder Funktionsmodule finden beispielsweise Verwendung in industriellen Automatisierungssystemen. Sie können als Feldgeräte ausgebildet sein, die digitale und/oder analoge Ein- und/oder Ausgabekanäle bereitstellen, oder als Signalwandler, Relaisbausteine, Zählerbausteine, Interfacemodule usw. ausgebildet sein. Durch Aneinanderreihen verschiedener dieser Module kann ein benötigtes Ein-/Ausgabesystem, auch als "Remote I/O (input/output) System" bezeichnet, auf einer Tragschiene zusammengesetzt werden, das über einen Feldbuskoppler (Feldbus-Gateway) und einen Feldbus mit einem oder mehreren zentralen Steuerungsrechnern, auch als Leitrechner oder speicherprogrammierbare Steuerung (SPS) bezeichnet, verbunden ist.

Aus der Druckschrift WO 2012/000807 A1 ist ein System derartiger Anschluss- und/oder Funktionsmodule bekannt, bei dem sowohl schmale, scheibenartige Module als auch breite, blockartige Module vorgesehen sind.

Die schmalen, scheibenartigen Module weisen eine Basiseinheit auf, auf die ein Elektronikgehäuse aufgesetzt ist, das wiederum eine oder mehrere Anschluss- und/oder Funktionseinheiten trägt. Die Basiseinheit ist auf eine Tragschiene aufsetzbar, insbesondere aufrastbar, und stellt zu beiden Seiten Busleiterkontakte bereit, die sowohl der Weiterleitung eines Datenbusses als auch der Weiterleitung eines Energiebusses zur Stromversorgung der Module dienen. Die Busleiterkontakte können als Gabel-/Messerkontakte oder als Druckkontakte ausgebildet sein. Im Inneren der Basiseinheit ist eine Steckvorrichtung für eine senkrecht zur Anreihrichtung einsteckbare Leiterplatte vorgesehen, die elektrisch mit den Busleiterkontakten verbunden ist. Die Busleiterkontakte der einen und der anderen Seite der Basiseinheit können zudem unmittelbar untereinander verbunden sein oder auch über die eingesteckte Leiterplatte. Die eingesteckte Leiterplatte ragt in das auf die Basiseinheit aufgesetzte Elektronikgehäuse und kontaktiert an ihrem anderen Ende Kontakte der Anschluss- und/oder Funktionseinheiten.

Im Unterschied zu diesen schmalen, scheibenartigen Anschluss- und Funktionsmodulen ist bei den breiten, blockartigen Anschluss- und Funktionsmodulen bevorzugt eine in Richtung der Tragschiene flach liegende Leiterplatte vorgesehen. Das Basiselement weist seinerseits eine der benötigten Breite des Anschluss- und/oder Funktionsmoduls entsprechende Breite auf, wobei wiederum zu beiden Seiten in Anreihrichtung die Buskontaktelemente ausgebildet sind. Auch im blockartigen Anschluss- und/oder Funktionsmodul sind die Buskontaktelemente beider Seiten leitend miteinander verbunden, zum Beispiel über Stromschienen oder eine Leiterplatte.

Nachteilig an den bekannten blockartigen Anschluss- und/oder Funktionsmodulen ist, dass für jede benötigte Breite eines Anschluss- und/oder Funktionsmoduls eine separate Basiseinheit konstruiert und hergestellt werden muss. Aufgrund der Anordnung der Busleiterkontakte an der Seite der Basiseinheit und aufgrund der notwendigen Verbindung der Busleiterkontakte von einer zur anderen Seite ist eine derartige Basiseinheit relativ komplex und somit in verschiedenen Größen nur kostenintensiv produzierbar.

Es ist daher eine Aufgabe der vorliegenden Erfindung, ein eingangs genanntes Anschluss- und/oder Funktionsmodul mit blockartigem Aufbau zu schaffen, das auf einfache Weise in verschiedenen Breiten herstellbar ist.

Diese Aufgabe wird gelöst durch ein Anschluss- und/oder Funktionsmodul mit den Merkmalen des unabhängigen Anspruchs. Vorteilhafte Ausgestaltungen und Weiterbildungen sind in den abhängigen Ansprüchen angegeben.

Ein erfindungsgemäßes Anschluss- und/oder Funktionsmodul der eingangs genannten Art zeichnet sich dadurch aus, dass die Basiseinheit in der Anreihrichtung Richtung modular aufgebaut ist und an jeder Seite eine Anschlusswange aufweist, die die jeweiligen Busleiterkontakte trägt sowie einen zwischen den Anschlusswangen angeordneten Distanzkörper.

Der in Richtung der Tragschiene somit dreiteilige Aufbau der Basiseinheit ermöglicht es, unabhängig von der Breite des Funktions- und Anschlussmoduls für jede Breite gleiche Anschlusswangen zu verwenden. Es braucht zur Anpassung der Breite des Funktions- und Anschlussmoduls nur der gegenüber den Anschlusswangen relativ einfach aufgebaute Distanzkörper angepasst zu werden, der in diesem Sinne als eine Art Abstandshalter für die Anschlusswangen dient.

In einer vorteilhaften Ausgestaltung weist das Anschluss- und/oder Funktionsmodul eine Leiterplatte auf, über die entsprechende Busleiterkontakte der beiden Anschlusswangen miteinander verbunden sind. Eine derartige Leiterplatte kann vorteilhaft sowohl der Verbindung der Busleiterkontakte von einer zur nächsten Seite dienen, also dem Durchschleifen des Busses durch das Anschluss- und/oder Funktionsmodul, als auch elektronische Komponenten des Anschluss- und/oder Funktionsmoduls aufnehmen.

Besonders bevorzugt weisen dabei die Anschlusswangen jeweils eine Aufnahme auf, in die die Leiterplatte senkrecht zur Anreihrichtung eingesteckt ist und in der die Leiterplatte die Busleiterklemmen mit Kontaktflächen elektrisch kontaktiert. Die senkrechte Einsteckbarkeit der Leiterplatte in die Anschlusswangen ermöglicht eine einfache Ausgestaltung der Busleiterkontakte. Zudem ist das vertikale Einstecken dann analog zu dem Einstecken einer vertikal ausgerichteten Leiterplatte bei den genannten schmalen, scheibenartigen Funktions- und Anschlussmodulen. Besonders bevorzugt können als Anschlusswangen in dem Fall die Basiseinheiten von solchen mechanisch und elektrisch kompatiblen flachen, scheibenartigen Funktions- und Anschlussmodulen verwendet werden. Auf diese Weise können blockartige Funktions- und Anschlussmodule leicht in eine Produktlinie mit scheibenförmigen Funktions- und Anschlussmodulen integriert werden.

In einer weiteren vorteilhaften Ausgestaltung des Anschluss- und/oder Funktionsmoduls weist die Leiterplatte mindestens einen ersten flach ausgerichteten Abschnitt und zwei dazu senkrecht stehende vertikale Abschnitte auf, die miteinander mechanisch und elektrisch verbunden sind. Eine flach liegende Leiterplatte ist zur Verbindung der Busleiterkontakte geeignet. Zudem wird entsprechend der weniger hohen, aber breiten Grundform des Anschluss- und/oder Funktionsmoduls eine große Leiterplattenfläche zur Aufnahme von elektronischen Komponenten bereitgestellt. Die vertikalen Abschnitte erlauben das vorteilhafte vertikale Einstecken der Leiterplatte in die Anschlusswangen. Die genannte Leiterplatte mit flach liegenden und vertikalen Abschnitten kombiniert die jeweiligen Vorteile.

Die unterschiedlich ausgerichteten Abschnitte der Leiterplatte können miteinander durch Lötverbinder verbunden sein. Besonders vorteilhaft ist jedoch eine Ausgestaltung der Leiterplatte, bei der die unterschiedlich ausgerichteten Abschnitte über flexible Abschnitte miteinander verbunden sind.

Um weiteren Leiterplattenplatz zur Aufnahme von elektronischen Komponenten bereitzustellen, kann optional ein zweiter flach ausgerichteter Abschnitt vorgesehen sein, der mit dem ersten flach ausgerichteten Abschnitt ebenfalls über mindestens einen flexiblen Abschnitt verbunden ist. Die beiden flach ausgerichteten Abschnitte können so platzsparend parallel zueinander und beabstandet voneinander in dem Anschluss- und/oder Funktionsmodul angeordnet sein. Zusätzlich zu den flexiblen Abschnitten kann eine elektrische Verbindung zwischen den beiden flach ausgerichteten Abschnitten über Steckkontaktleisten oder vergleichbare Steckkontakte erzielt werden.

In einer weiteren vorteilhaften Ausgestaltung des Anschluss- und/oder Funktionsmoduls sind die Anschlusswangen mit dem Distanzkörper verrastet, wodurch eine schnelle, unaufwändige und in diesem Schritt werkzeuglose Montage gegeben ist.

In einer weiteren vorteilhaften Ausgestaltung des Anschluss- und/oder Funktionsmoduls weisen die Anschlusswangen lösbare Rastmittel zur Verrastung mit der Tragschiene auf. Besonders bevorzugt weisen nur die Anschlusswangen, und nicht der Distanzkörper derartige Rastmittel auf, um den Distanzkörper möglichst einfach zu halten.

In einer weiteren vorteilhaften Ausgestaltung des Anschluss- und/oder Funktionsmoduls ist auf dem Gehäusedeckel ein Tragschienenabschnitt montiert. So können beispielsweise Reihenklemmen aufgesetzt werden, beispielsweise um das Anschluss- und/oder Funktionsmodul komfortabel verdrahten zu können und/oder Signalwandler o.ä. vor- bzw. nachschalten zu können.

Die Erfindung wird nachfolgend anhand von Ausführungsbeispielen mithilfe von Figuren näher erläutert. Die Figuren zeigen:
- Fig. 1: eine perspektivische Darstellung eines blockartigen Anschluss- und Funktionsmoduls;
- Fig. 2: das Anschluss- und Funktionsmodul der Fig. 1 mit aufgesetztem Reihenklemmenblock;
- Fig. 3: eine Explosionsdarstellung des Anschluss- und Funktionsmoduls der Fig. 1;
- Fig. 4 und 5: jeweils eine perspektivische teilgeschnittene Darstellung des Anschluss- und Funktionsmoduls; und
- Fig. 6a und 6b: eine weitere perspektivische teilgeschnittene Darstellung des Anschluss- und Funktionsmoduls (Fig. 6a) und eine Ausschnittvergrößerung desselben (Fig. 6b).

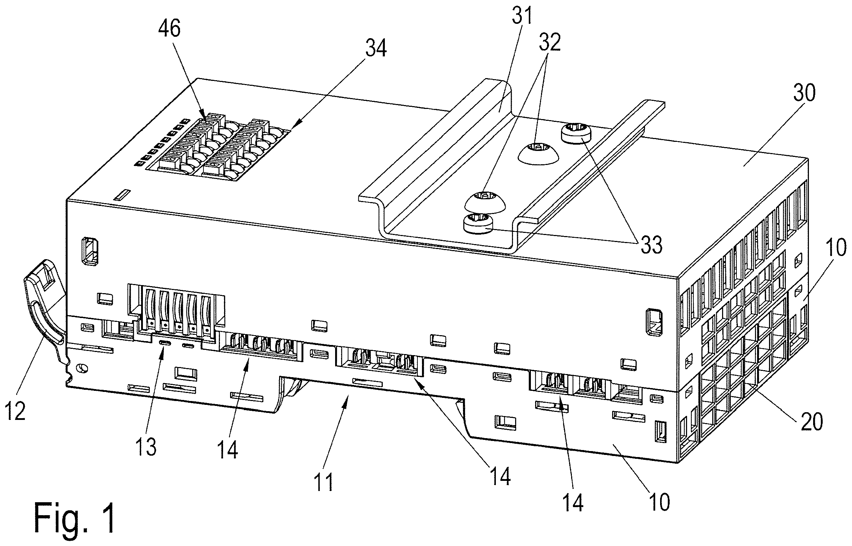

Fig. 1 zeigt in einer schematischen perspektivischen Darstellung ein Ausführungsbeispiel eines Anschluss- und/oder Funktionsmoduls. Das Anschluss- und/oder Funktionsmodul ist zum Aufsetzen auf eine Tragschiene, beispielsweise eine übliche Hutschiene ausgebildet. In den Figuren ist das Anschluss- und/oder Funktionsmodul jeweils ohne Tragschiene flach liegend dargestellt. Auf diese Ausrichtung, die einer Montage des Anschluss- und/oder Funktionsmoduls auf einer ebenfalls horizontal verlaufende Tragschiene entsprechen würde, beziehen sich nachfolgend benutzte Angaben wie oben, unten, vertikal und horizontal. Als eine horizontale Ebene ist somit eine parallel zur Tragschiene verlaufende Ebene zu verstehen. Entsprechend ist unter einer vertikalen Ebene bzw. einer vertikalen Ausrichtung eine senkrecht zur Horizontalebene verlaufende Ebene bzw. Ausrichtung zu verstehen.

Das Anschluss- und/oder Funktionsmodul weist in einem unteren, der Tragschiene zugewandten Abschnitt eine Basiseinheit auf, die aus jeweils einer seitlichen Anschlusswange 10 und einem Distanzkörper 20 besteht.

An den Anschlusswangen 10 ist in ihrem unteren mittleren Bereich eine Tragschienenaufnahme 11 ausgebildet, mit der das Anschluss- und/oder Funktionsmodul auf eine Tragschiene montiert, bevorzugt aufgerastet werden kann. Im Bereich der Tragschienenaufnahme 11 sind dazu hier nicht näher bezeichnete Rastmittel vorgesehen. Diese Rastmittel stehen mit einem Betätigungshebel 12 in Verbindung, über den eine Verrastung mit der Tragschiene gelöst werden kann, um das Anschluss- und/oder Funktionsmodul von der Tragschiene zu entnehmen.

Weiterhin weisen die Anschlusswangen 10 an ihrer Seite eine Mehrzahl von Busleiterkontakten 13, 14 auf, mit denen sie in elektrischen Kontakt zu komplementären Busleiterkontakten benachbarter Anschluss- und/oder Funktionsmodule stehen. Vorliegend sind zwei verschiedene Gruppen von Busleiterkontakten 13, 14 vorgesehen. Die Busleiterkontakte 13 sind als Druckkontakte ausgebildet und sind Teil eines Signal- und/oder Datenbusses. Die Busleiterkontakte 14 sind als Gabel-/Messerkontakte ausgebildet und sind Teil eines Energie- bzw. Stromversorgungsbusses.

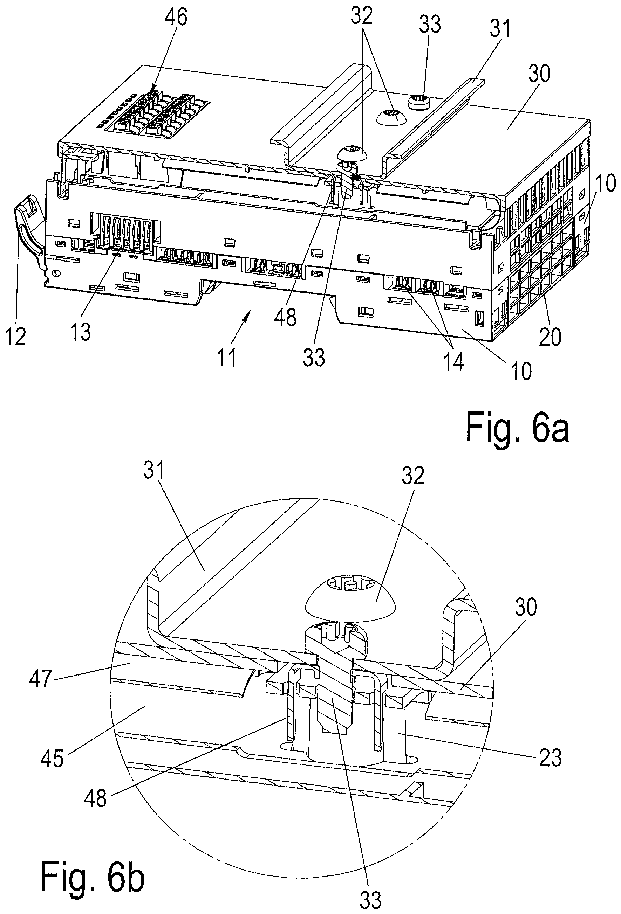

Auf die Basiseinheit ist ein Gehäusedeckel 30 aufgesetzt, der an seiner Oberseite in diesem Ausführungsbeispiel einen Tragschienenabschnitt 31 trägt. Der Tragschienenabschnitt 31 ist mittels Befestigungsschrauben 32 auf dem Gehäusedeckel 30 festgelegt. Die Befestigungsschrauben 32 dienen dabei auch der Festlegung des Gehäusedeckels 30 auf der Basiseinheit. Mithilfe von zwei weiteren durch den Tragschienenabschnitt 31 geführten Schrauben 33 wird eine Erdung des Tragschienenabschnitts 31 erzielt. Dieses ist detaillierter im Zusammenhang mit Fig. 6 beschrieben.

Durch eine Aussparung 34 im Gehäusedeckel 30 ragt ein oberer Teil eines Anschlussblocks 46, der einem Anschluss von Leitern an das Anschluss- und/oder Funktionsmodul dient. Der Anschlussblock stellt Anschlüsse vorzugsweise, aber nicht zwingend, als Anschlüsse in Direktstecktechnik (push-in) bereit, die werkzeugfrei durch Einstecken eines Leiters in einen Anschluss kontaktierbar sind. Die Anschlüsse des Anschlussblocks 46 können auch als Schraubanschlüsse, Zugfederanschlüsse, IDC-Anschlüsse oder als Steckverbinder ausgebildet sein.

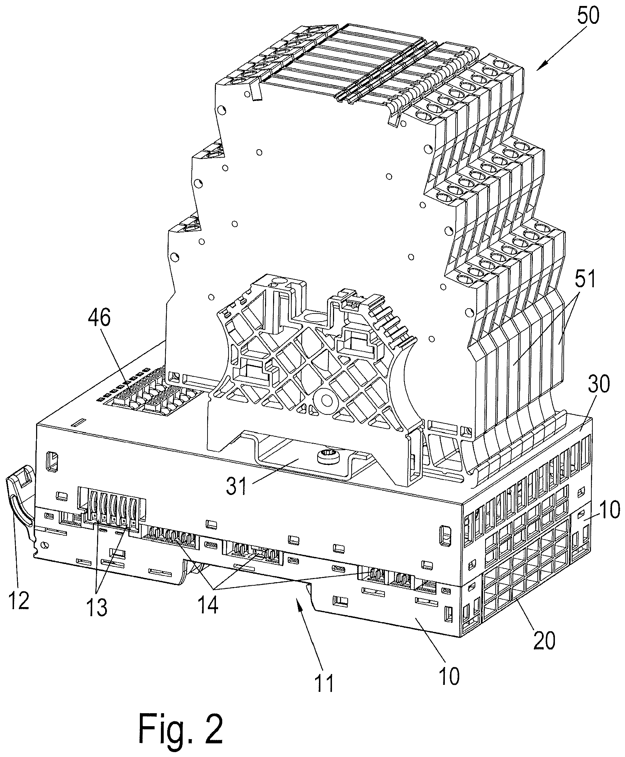

Fig. 2 zeigt ebenfalls in perspektivischer Darstellung das Anschluss- und/oder Funktionsmodul der Fig. 1 mit einem auf den Tragschienenabschnitt 31 aufgesetzten Reihenklemmenblock 50. Der Reihenklemmenblock 50 setzt sich aus einer Mehrzahl von Reihenklemmen 51 zusammen, die der Weiterführung und Verteilung einer Verdrahtung an dem Anschlussblock 46 dienen.

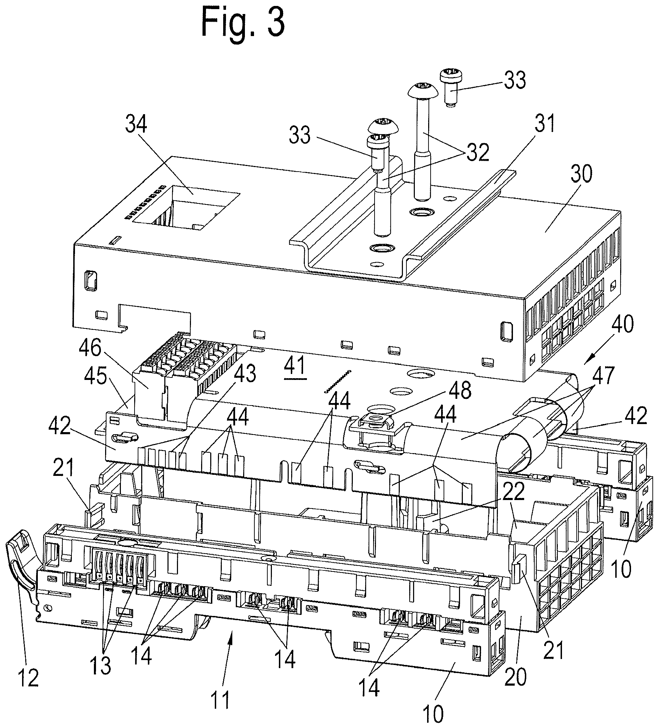

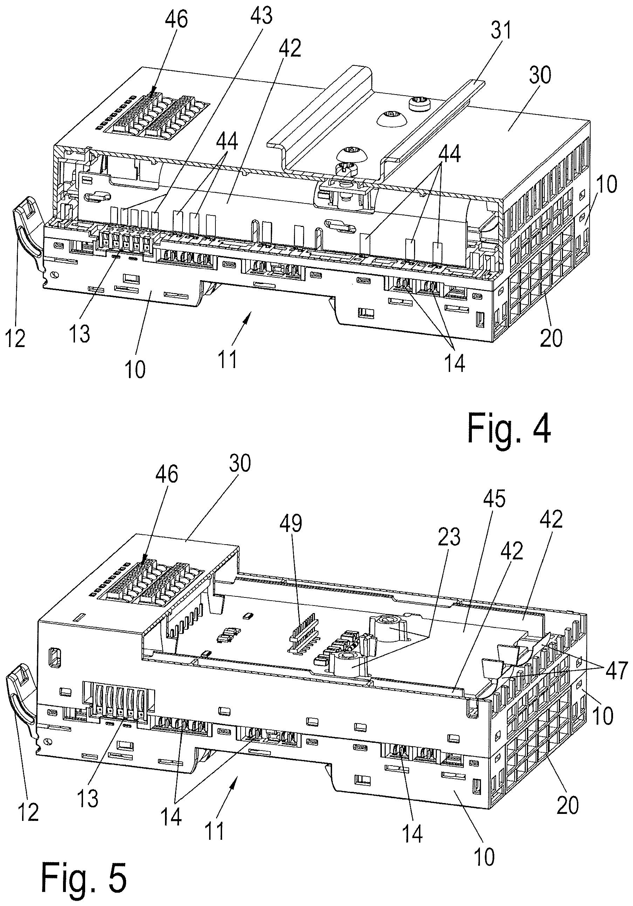

Details des Aufbaus des Anschluss- und/oder Funktionsmoduls der Fig. 1 bzw. 2 gehen aus den nachfolgend beschriebenen Figuren 3 bis 5 hervor. Fig. 3 ist eine perspektivische Explosionsdarstellung des Anschluss- und/oder Funktionsmoduls, wohingegen die Fig. 4 bis 6 verschiedene teilgeschnittene Ansichten des Anschluss- und/oder Funktionsmoduls zeigen.

Fig. 3 zeigt, dass die Anschlusswangen 10 jeweils seitlich an den Distanzkörper 20 angesetzt werden und mit diesem verrasten. Dazu sind am Distanzkörper 20, der von seiner Grundform her wannenförmig ausgebildet ist, Rasthaken 21 angeordnet, die in entsprechende Öffnungen der Anschlusswangen 10 eingreifen und dort mit diesen verrasten. Der Distanzkörper 20 weist im mittleren unteren Bereich eine Ausbuchtung auf, durch die die Tragschiene verläuft. Rastmittel zum Festlegen des Distanzkörpers 20 auf der Tragschiene können optional vorgesehen sein. Eine Verrastung mit der Tragschiene nur im Bereich der Anschlusswangen 10 ist jedoch ausreichend.

Sämtliche Elemente zur Kontaktierung und Weiterleitung des Daten- bzw. des Stromversorgungsbusses sind in den Anschlusswangen 10 angeordnet. Die Busleiterkontakte 13, 14 an den Anschlusswangen 10 sind so ausgebildet, dass sie eine senkrecht in die Anschlusswangen 10 eingesteckte Leiterplatte kontaktieren. Dazu weisen die Busleiterkontakte 13, 14 in den Figuren nicht sichtbare, nach innen weisende Kontaktzungen auf. Entsprechend kann der Distanzkörper 20 ein reines Kunststoff-Spritzgussteil sein, das keine elektrisch kontaktierenden Elemente aufweist, wodurch er einfach in verschiedenen Breiten hergestellt werden kann.

Alle weiteren elektrischen und/oder elektronischen Komponenten des Anschluss- und/oder Funktionsmoduls sind auf einer Leiterplatte 40 angeordnet, die mehrere starre sowie mehrere flexible Abschnitte aufweist. Die Leiterplatte 40 weist einen ersten starren flachen Abschnitt 41 auf, der flach liegend im Anschluss- und/oder Funktionsmodul unterhalb des Gehäusedeckels 30 angeordnet ist. In Anreihrichtung des Anschluss- und/oder Funktionsmoduls ist an jeder Seite der erste flache Abschnitt 41 über einen flexiblen Abschnitt 47 mit je einem starren vertikalen Abschnitt 42 verbunden. An jedem der beiden vertikalen Abschnitte 42 sind Kontaktflächen 43 und 44 ausgebildet, die bei einem Einstecken des vertikalen Abschnitts 42 in die Anschlusswangen 10 die Busleiterkontakte 13, 14 kontaktieren. Die Kontaktflächen 43, 44 stehen über Leiterbahnen, die auf der Leiterplatte 40 ausgebildet sind, mit den entsprechenden Kontaktflächen 43, 44 des gegenüberliegenden vertikalen Abschnitts 42 in Verbindung. Die Leiterbahnen verlaufen dabei über die flexiblen Abschnitte 47 und den ersten flachen Abschnitt 41.

Die Leiterplatte 40 umfasst einen zweiten flachen Abschnitt 45, der über weitere flexible Abschnitte 47 ebenfalls mit dem ersten flachen Abschnitt 41 verbunden ist. Im eingebauten Zustand der Leiterplatte 40 ist der zweite flache Abschnitt 45 gewissermaßen unter den ersten Abschnitt 41 geklappt und ist damit parallel und beabstandet zu dem ersten flachen Abschnitt 41 angeordnet.

Auf dem zweiten flachen Abschnitt 45 ist der Anschlussblock 46 eingelötet. Elektronische Komponenten des Anschluss- und/oder Funktionsmoduls, beispielsweise eine Busanschaltung sowie Funktionselektronik, die mit dem Anschlussblock 46 und der Busanschaltung in Verbindung steht, kann sowohl auf dem ersten als auch auf dem zweiten flachen Abschnitt 41, 45 angeordnet sein.

Der zweite flache Abschnitt 45 der Leiterplatte 40 wird von Stegen 22, die im Distanzkörper 20 ausgebildet sind, von unten unterstützt und seitlich festgelegt. Weiterhin sind im Distanzkörper 20 Schraubdome 23 ausgeformt, die durch entsprechende Öffnungen der flachen Abschnitte 41, 45 der Leiterplatte 40 geführt sind und in die von oben die weiteren Befestigungsschrauben 32 eingeschraubt sind. Auch auf diese Weise ist zum einen die Leiterplatte 40 seitlich festgelegt und zum anderen der Gehäusedeckel 30 mit dem Distanzkörper 20 verschraubt. Am Gehäusedeckel 30 ist weiterhin ein nach innen weisender kreuzförmiger Stift ausgebildet, der durch eine Öffnungen in dem oberen flachen Abschnitt 41 auf den unteren flachen Abschnitt 45 drückt und ihn so ebenfalls festlegt.

Die in die Anschlusswangen 10 eingesteckten vertikalen Abschnitte 42 der Leiterplatte 40 und das Zusammenwirken der Kontaktflächen 43 und 44 mit den Busleiterkontakten 13, 14 ist im teilgeschnittenen Bild in Fig. 4 nochmals gut zu erkennen.

Elektrische Verbindungen zwischen dem ersten und dem zweiten flachen Abschnitt 41, 45 der Leiterplatte 40 sind über die flexiblen Bereiche 47 geführt. Zusätzlich kann vorgesehen sein, miteinander kontaktierende Steckkontaktleisten 49 auf der Unterseite des ersten flachen Abschnittes 41 und der Oberseite des zweiten flachen Abschnitts 45 anzuordnen, die beim Umklappen des zweiten flachen Abschnitts 45 unter den ersten flachen Abschnitt 41 ineinandergesteckt werden und so zusätzliche elektrische Kontakte zwischen den beiden Abschnitten 41 und 45 darstellen. Dieses ist im teilgeschnittenen Bild der Fig. 5 erkennbar.

Die ebenfalls teilgeschnittene Darstellung der Fig. 6a und insbesondere der vergrößerte Ausschnitt in Fig. 6b zeigen die Erdung des Tragschienenabschnitts 31 näher. In die Leiterplatte 40 ist auf jeder Seite ein Erdungselement 48 eingelötet, das über die Leiterplatte 40 mit einem Funktionserde-Potential beaufschlagt ist. Dieses wird z.B. der Tragschiene, auf die das Anschluss- und/oder Funktionsmodul aufgesetzt ist, entnommen. Die Erdungselemente 48 weisen jeweils ein Schraubgewinde auf, in das jeweils eine der von oben durch den Tragschienenabschnitt 31 geführten Schrauben 33 eingeschraubt ist. Eine Erdung erfolgt so zum einen über diese Schrauben 33. Zum anderen ist der Bereich der Erdungselemente 48 in dem Gehäusedeckel 30 ausgespart, so dass die Erdungselemente 48 den Tragschienenabschnitt 31 von unten auch unmittelbar kontaktieren, wodurch eine besonders gute, niederohmige Erdung sichergestellt wird.

Besonders vorteilhaft können als Anschlusswangen 10 die Basiseinheiten eines flachen, scheibenförmigen Anschluss- und/oder Funktionsmoduls verwendet werden. Solche Anschlusswangen 10 tragen dann Busleiterkontakte 13, 14 auch auf der Seite, mit der sie am Distanzkörper 20 anliegen. Der Distanzkörper 20 ist entsprechend gegebenenfalls mit Ausnehmungen oder Vertiefungen versehen, in die eventuell hervorstehende Abschnitte der Busleiterkontakte 13, 14 hineinragen können.

### Bezugszeichenliste

- 10: Anschlusswange
- 11: Tragschienenaufnahme
- 12: Betätigungshebel
- 13, 14: Busleiterkontakte

- 20: Distanzkörper
- 21: Rasthaken
- 22: Steg
- 23: Schraubdom

- 30: Gehäusedeckel
- 31: Tragschienenabschnitt
- 32: Befestigungsschraube
- 33: Schraube
- 34: Aussparung

- 40: Leiterplatte
- 41: erster flacher Abschnitt
- 42: vertikaler Abschnitt
- 43, 44: Kontaktfläche
- 45: zweiter flacher Abschnitt
- 46: Anschlussblock
- 47: flexibler Abschnitt
- 48: Erdungskontakt
- 49: Steckkontaktleiste

- 50: Reihenklemmenblock
- 51: Reihenklemme

## Patentansprüche

1. Busfähiges aneinanderreihbares Anschluss- und/oder Funktionsmodul zur Steuerung und/oder Überwachung technischer Prozesse mit einem blockartigen Aufbau, aufweisend
- eine Basiseinheit zur Befestigung an einer Tragschiene, wobei die Basiseinheit in Anreihrichtung an jeder Seite wenigstens eine Busleiterklemme (13, 14) zur Weiterleitung von wenigstens einem Energie- und/oder Datenbus in Anreihrichtung an benachbarte Anschluss- und/oder Funktionsmodule aufweist und
- einen auf die Basiseinheit aufgesetzten Gehäusedeckel (30), **dadurch gekennzeichnet, dass**
die Basiseinheit in der Anreihrichtung modular aufgebaut ist und an jeder Seite eine Anschlusswange (10) aufweist, die die Busleiterkontakte (13, 14) trägt, sowie einen zwischen den Anschlusswangen (10) angeordneten Distanzkörper (20).

2. Anschluss- und/oder Funktionsmodul nach Anspruch 1, aufweisend eine Leiterplatte (40), über die entsprechende Busleiterkontakte (13, 14) der beiden Anschlusswangen (10) miteinander verbunden sind.

3. Anschluss- und/oder Funktionsmodul nach Anspruch 2, bei dem die Anschlusswangen (10) jeweils eine Aufnahme aufweisen, in die die Leiterplatte (40) senkrecht zur Anreihrichtung eingesteckt ist und in der die Leiterplatte (40) die Busleiterklemmen (13, 14) mit Kontaktflächen (43, 44) elektrisch kontaktiert.

4. Anschluss- und/oder Funktionsmodul nach Anspruch 3, bei dem die Leiterplatte (40) mindestens einen ersten flach ausgerichteten Abschnitt (41) und zwei dazu senkrecht stehende vertikale Abschnitte (42) aufweist, die miteinander mechanisch und elektrisch verbunden sind.

5. Anschluss- und/oder Funktionsmodul nach Anspruch 4, bei dem der erste flach ausgerichtete Abschnitt (41) über flexible Abschnitte (47) mit den beiden vertikalen Abschnitten (42) verbunden ist.

6. Anschluss- und/oder Funktionsmodul nach Anspruch 5, bei dem die Leiterplatte (40) einen zweiten flach ausgerichteten Abschnitt (45) aufweist, der mit dem ersten flach ausgerichteten Abschnitt (41) ebenfalls über mindestens einen flexiblen Abschnitt (47) verbunden ist.

7. Anschluss- und/oder Funktionsmodul nach Anspruch 6, bei dem miteinander kontaktierende Steckkontaktleisten (49) an dem ersten flachen Abschnittes (41) und an dem zweiten flachen Abschnitt (45) angeordnet sind, die im montierten Zustand der Leiterplatte (40) ineinandergesteckt sind.

8. Anschluss- und/oder Funktionsmodul nach einem der Ansprüche 1 bis 7, bei dem die Anschlusswangen (10) mit dem Distanzkörper (20) verrastet sind.

9. Anschluss- und/oder Funktionsmodul nach einem der Ansprüche 1 bis 8, bei dem die Anschlusswangen (10) lösbare Rastmittel zur Verrastung mit der Tragschiene aufweisen.

10. Anschluss- und/oder Funktionsmodul nach einem der Ansprüche 1 bis 9, bei dem auf dem Gehäusedeckel (30) ein Tragschienenabschnitt (31) montiert ist.

## Claims

1. A bus-capable stackable connection and/or function module for controlling and/or monitoring technical processes with a block-like structure, comprising
- a base unit for fastening to a carrier rail, wherein the base unit has, on each side in the direction of stacking, at least one bus conductor terminal (13, 14) for forwarding at least one energy bus and/or data bus in the direction of stacking to adjacent connection and/or function modules, and
- a housing cover (30) placed on the base unit,
**characterized in that**
the base unit is modularly laid out in the direction of stacking and has a connection flange (10) on each side, which flange supports the bus conductor contacts (13, 14), as well as a spacer body (20) arranged between the connection flanges (10).

2. A connection and/or function module according to claim 1, comprising a printed circuit board (40), by means of which corresponding bus conductor contacts (13, 14) of the two connecting flanges (10) are connected to one another.

3. A connection and/or function module according to claim 2, wherein the connection flanges (10) each have a receptacle into which the circuit board (40) is inserted perpendicular to the direction of stacking, and in which the circuit board (40) connects the bus conductor terminals (13, 14) with contact surfaces (43, 44).

4. A connection and/or function module according to claim 3, wherein the printed circuit board (40) has at least one first flat-aligned section (41) and two vertical sections (42) standing perpendicular thereto, which are mechanically and electrically connected to one another.

5. A connection and/or function module according to claim 4, wherein the first flat-aligned section (41) is connected to the two vertical sections (42) via flexible sections (47).

6. A connection and/or function module according to claim 5, wherein the printed circuit board (40) has a second flat-aligned section (45) which is also connected to the first flat-aligned section (41) by way of at least one flexible section (47).

7. A connection and/or function module according to claim 6, wherein mutually contacting plug-contact strips (49) are arranged on the first flat section (41) and on the second flat section (45), which are plugged together in the assembled state of the printed circuit board (40).

8. A connection and/or function module according to one of the claims 1 to 7, wherein the connection flanges (10) are latched with the spacer body (20).

9. A connection and/or function module according to one of the claims 1 to 8, wherein the connection flanges (10) have releasable latching means for latching with the carrier rail.

10. A connection and/or function module according to one of the claims 1 to 9, wherein a carrier rail section (31) is mounted on the housing cover (30).

## Revendications

1. Module de raccordement et/ou fonctionnel compatible avec un bus pouvant être aligné en série selon une structure en bloc pour la commande et/ou la surveillance de processus techniques, comprenant
- une unité de base à fixer sur un rail de support, laquelle unité de base présente de chaque côté, dans le sens d'alignement, au moins une borne pour conducteur de bus (13, 14) pour l'acheminement d'au moins un bus d'énergie et/ou de données dans le sens d'alignement vers des modules de raccordement et/ou fonctionnels voisins et
- un couvercle de boîtier (30) posé sur l'unité de base,
**caractérisé en ce que** l'unité de base est construite de façon modulaire dans le sens d'alignement et présente de chaque côté un flasque de raccordement (10) qui porte les contacts pour conducteur de bus (13, 14), ainsi qu'un élément d'écartement (20) disposé entre les flasques de raccordement (10).

2. Module de raccordement et/ou fonctionnel selon la revendication 1, présentant une carte de circuits (40) par laquelle les contacts pour conducteur de bus (13, 14) correspondants des deux flasques de raccordement (10) sont connectés les uns aux autres.

3. Module de raccordement et/ou fonctionnel selon la revendication 2, dans lequel les flasques de raccordement (10) présentent chacun un logement dans lequel la carte de circuits (40) est insérée perpendiculairement au sens d'alignement et dans lequel la carte de circuit (40) vient en contact électrique avec les bornes pour conducteurs de bus (13, 14) à l'aide de surfaces de contact (43, 44).

4. Module de raccordement et/ou fonctionnel selon la revendication 3, dans lequel la carte de circuit (40) présente au moins une première partie orientée à plat (41) et deux parties verticales (42) perpendiculaires à celle-ci, qui sont reliées entre elles mécaniquement et électriquement.

5. Module de raccordement et/ou fonctionnel selon la revendication 4, dans lequel la première partie orientée à plat (41) est reliée par des parties flexibles (47) aux deux parties verticales (42).

6. Module de raccordement et/ou fonctionnel selon la revendication 5, dans lequel la carte de circuits (40) présente une deuxième partie orientée à plat (45) qui est également reliée à la première partie orientée à plat (41) par au moins une partie flexible (47).

7. Module de raccordement et/ou fonctionnel selon la revendication 6, dans lequel des barrettes de contacts enfichables (49) en contact les unes avec les autres sont disposées sur la première partie plate (41) et la deuxième partie plate (45) et sont enfichées les unes dans les autres dans l'état monté de la carte de circuits (40).

8. Module de raccordement et/ou fonctionnel selon l'une des revendications 1 à 7, dans lequel les flasques de raccordement (10) sont enclenchés avec les éléments d'écartement (20).

9. Module de raccordement et/ou fonctionnel selon l'une des revendications 1 à 8, dans lequel les flasques de raccordement (10) présentent des moyens d'enclenchement qui peuvent être défaits pour l'enclenchement sur le rail de support.

10. Module de raccordement et/ou fonctionnel selon l'une des revendications 1 à 9, dans lequel une partie de rail de support (31) est montée sur le couvercle de boîtier (30).
